# EUROPEAN PATENT SPECIFICATION

(11) **EP 3 547 349 B1**
(45) Date of publication and mention of the grant of the patent: **21.10.2020**
(21) Application number: 17881721.9
(22) Date of filing: 06.12.2017
(51) Int. Cl.: H01L 21/02, H01L 21/3065

(54) **METHOD FOR REDUCING SILICON CARBIDE EPITAXIAL BASAL PLANE DISLOCATION DENSITY**
VERFAHREN ZUR REDUZIERUNG DER VERSETZUNGSDICHTE EINER SILICIUMCARBID-EPITAXIALBASISEBENE
PROCÉDÉ DE RÉDUCTION DE DENSITÉ DE DISLOCATION DE PLAN BASAL ÉPITAXIAL DE CARBURE DE SILICIUM

(30) Priority: 15.12.2016 CN 201611158953
(43) Date of publication of application: 02.10.2019
(73) Proprietor: China Electronics Technology Group Corporation No.55 Research Institute, Nanjing, Jiangsu 210016 (CN)
(72) Inventor: LI, Yun, Nanjing Jiangsu 210016 (CN)
(74) Representative: Hanna Moore + Curley
(86) International application number: PCT/CN2017/114686
(87) International publication number: WO 2018/108006

(56) References cited:
- EP-A2- 1 739 727
- CN-A- 103 295 884
- CN-A- 104 851 781
- CN-A- 105 244 255
- CN-A- 105 826 186
- CN-A- 107 068 539
- US-A1- 2014 220 325

## Description

### Technical Field

The present invention relates to a growth method of a silicon carbide epitaxial layer, and more particularly relates to a method for reducing a silicon carbide epitaxial basal plane dislocation density.

### Background Art

The commercialization of silicon carbide power electronics is mainly limited by structural defects in a silicon carbide epitaxial layer. The structural defects will lead to degradation of silicon carbide device performance and cause problems of a decrease in breakdown voltage, shortening of the minority carrier lifetime, an increase in forward conduction resistance, an increase in the magnitude of leakage and the like. A long-term goal of a silicon carbide research is to eliminate these defects.

At present, the main problem in the research on the silicon carbide bipolar devices is to reduce the generation of stacking faults from Basal plane dislocation (BPD) in an active region of a device under a forward bias. The stacking fault leads to the degradation over time of the device performance and increases a conduction voltage drop and on-state energy loss. In order to avoid the degradation of the device performance, it is necessary to avoid BPD defects in a substrate from entering an epitaxial layer.

At present, an internationally commonly used method for reducing BPD defects in the epitaxial layer is to form a BPD etch pit by KOH or KOH-NaOH-MgO co-molten etching on a silicon carbide substrate, then perform epitaxial growth on the etched substrate, and close a BPD defect transfer passageway through a lateral epitaxial growth in order to convert the BPD defect into a TED (Threading Edge Dislocation) defect with the same Burgers vector. The TED defect is relatively less harmful to the device. However, the KOH molten etching or KOH-NaOH-MgO co-molten etching of the silicon carbide substrate severely damages the surface of the silicon carbide substrate, and the process is relatively cumbersome and is not suitable for silicon carbide epitaxial process integration.

Patent specification CN 105826186 describes a method of growing silicon carbide epitaxial layer by special layer buffer design, comprising in-situ HCl/H2 etching treatment prior to the growth of a buffer layers.

Patent specification US 2014/220325 describes a method of forming silicon carbide crystals and wafers.

Patent specification EP 1739727 describes a composite structure having a silicon carbide epitaxial layer, wherein the epitaxial layer includes at least four regions arranged vertically and defining respective interfaces.

### Summary of the Invention

Invention objective: for the above problems, the present invention provides a method for reducing a silicon carbide epitaxial basal plane dislocation density.

Technical solution: in order to achieve the objective of the present invention, the technical solution adopted by the present invention is: a method for growing a silicon carbide epitaxial layer with reduced basal plane dislocation density, including the following steps:
(1) placing a silicon carbide substrate deflected towards a direction <11-20> at 4 degrees or 8 degrees, on a graphite susceptor in a reaction chamber of a silicon carbide epitaxial system;
(2) replacing gas in the reaction chamber by argon, then introducing hydrogen into the reaction chamber, gradually increasing the flow rate of the hydrogen to 60 to 120 L/min, setting a pressure in the reaction chamber to be 80 to 200 mbar, gradually heating the reaction chamber to 1,550 to 1,700°C, maintaining all parameters constant after the temperature reaches a set temperature, and performing in-situ hydrogen etching treatment on the silicon carbide substrate for 5 to 15 min;
(3) after the in-situ hydrogen etching treatment is completed, introducing a silicon source and a carbon source into the reaction chamber such that the flow rate ratio of the silicon source to the hydrogen is smaller than 0,03%, the C/Si ratio at the gas inlet end is controlled to be 0.9, and introducing a doping source to grow a buffer layer 1 with a thickness of 0.2 to 0.5 µm and a doping concentration of 2 to 5E18 cm⁻³;
(4) turning off the silicon source and the carbon source and the doping source, maintaining the pressure in the reaction chamber, the growth temperature and the flow rate of the hydrogen constant, and performing in-situ hydrogen etching treatment on the buffer layer 1 for 2 to 10 min;
(5) introducing the silicon source and the carbon source into the reaction chamber, such that the flow rate ratio of the silicon source to the hydrogen is the same as that in the step (3) and the C/Si ratio at the gas inlet end is controlled to be 1.2; introducing the doping source to grow a buffer layer 2 with a thickness of 0.2 to 0.5 µm and a doping concentration of 5 to 8E17 cm⁻³;
(6) turning off the silicon source and the carbon source and the doping source, maintaining the pressure in the reaction chamber, the growth temperature and the flow rate of the hydrogen constant, and performing in-situ hydrogen etching treatment on the buffer layer 2 for 2 to 10 min;
(7) repeating the steps (3) to (6) to complete the growth of a composite buffer layer;
(8) introducing the silicon source and the carbon source and the doping source, changing the flow rates of the silicon source and the carbon source and the doping source to set values required for growing an epitaxial structure in a gradual, linear manner, and growing the epitaxial structure ; and
(9) after the growth of the epitaxial structure is completed, turning off the growth source and the doping source, reducing the temperature of the reaction chamber to room temperature in a hydrogen atmosphere, then discharging the hydrogen, introducing argon to replace the gas in the reaction chamber, increasing the pressure in the reaction chamber to an atmospheric pressure by the argon, and opening the chamber to take out a wafer.

Beneficial effects: compared with the prior art, the present invention has the advantages that the highly-lightly doped structural composite buffer layer having a plurality of cycles is epitaxially grown on the SiC substrate, each single layer of buffer layer is subjected to interfacial high-temperature hydrogen etching treatment, a plurality of interfaces are introduced by the interfacial high-temperature treatment and direct doping concentration variation, and conversion of BPD (Basal Plane Dislocation) defects to TED (Threading Edge Dislocation) defects is promoted using an interfacial image force, so that the BPD defects in an epitaxial layer are greatly reduced. The method is simple in process and favorable for epitaxial process integration. Meanwhile, complicated pretreatment of the SiC substrate is avoided, and damage to the surface of the substrate is reduced.

### Brief Description of the Drawings

Fig. 1 is a structural schematic diagram of an epitaxial wafer grown according to the present invention;
Fig. 2 is a PL (photoluminescence) imaging BPD (Basal Plane Dislocation) defect analysis result of an SiC epitaxial wafer with one composite buffer layer grown; and
Fig. 3 is a PL imaging BPD defect analysis result of an SiC epitaxial wafer with two composite buffer layers grown.

### Detailed Description of the Invention

The technical solution of the present invention is further described below in combination of accompanying drawings and examples.

A method for reducing a silicon carbide epitaxial basal plane dislocation density of the present invention greatly reduces BPD (Basal Plane Dislocation) defects in an epitaxial layer mainly by epitaxially growing a high-low doping concentration composite buffer layer having a plurality of cycles on an SiC substrate, performing interfacial high-temperature hydrogen etching treatment on each single layer of buffer layer, introducing a plurality of interfaces using the interfacial high-temperature treatment and doping induction, and promoting conversion of BPD defects to TED (Threading Edge Dislocation) defects using an interfacial image force. The method is simple in process and favorable for epitaxial process integration. Meanwhile, complicated pretreatment of the SiC substrate is avoided, and damage to the surface of the substrate is reduced. The method specifically includes the following steps that:
(1) a silicon carbide substrate is placed on a graphite susceptor in a reaction chamber of an SiC epitaxial system, wherein the graphite susceptor is provided with a tantalum carbide coating layer, and the silicon carbide substrate may use a silicon-plane silicon carbide substrate deflected towards a direction <11-20> at 4 degrees or 8 degrees;
(2) gas in the reaction chamber is replaced by argon then hydrogen is introduced into the reaction chamber; the flow rate of the hydrogen is gradually increased to 60 to 120 L/min; a pressure in the reaction chamber is set to be 80 to 200 mbar; the reaction chamber is gradually heated to 1,550 to 1,700°C; all parameters are maintained constant after the temperature reaches a set temperature, and in-situ hydrogen etching treatment is performed on the silicon carbide substrate for 5 to 15 min;
(3) a silicon source and a carbon source at small flow rates are introduced into the reaction chamber, wherein the silicon source may be silane, dichloro hydrogen silicon, trichlorosilane, tetrachloro hydrogen silicon, etc., and the carbon source may be methane, ethylene, acetylene, propane, etc.; the flow rate ratio of the silicon source to the hydrogen is controlled to be smaller than 0.03%; the flow rate of the carbon source is adjusted; the C/Si ratio at the gas inlet end is controlled to be 0.9, and an n-type doping source high-purity nitrogen (N₂) or a p-type doping source trimethylaluminum (TMA) is introduced, namely 500 sccm of high-purity nitrogen (N₂) may be introduced; the growth time is set to be 6 min, and a buffer layer 1 with a thickness of 0.2 to 0.5 µm and a doping concentration of 2 to 5E18 cm⁻³ is grown;
(4) a growth source and the doping source are turned off, the pressure in the reaction chamber, the growth temperature and the flow rate of the H₂ are maintained constant, and in-situ hydrogen etching treatment is performed on the buffer layer 1 for 2 to 10 min;
(5) the silicon source and the carbon source at small flow rates are introduced into the reaction chamber, wherein the flow rate of the silicon source is the same as that in the step (3); the flow rate of the carbon source is increased; the C/Si ratio at the gas inlet end is controlled to be 1.2, and the n-type doping source high-purity nitrogen (N₂) or p-type doping source trimethylaluminum (TMA) is introduced, namely 500 sccm of high-purity nitrogen (N₂) may be introduced; the growth time is set to be 6 min, and a buffer layer 2 with a thickness of 0.2 to 0.5 µm and a doping concentration of 5 to 8E17 cm⁻³ is grown;
(6) the growth source and the doping source are turned off, the pressure in the reaction chamber, the growth temperature and the flow rate of the H₂ are maintained constant, and in-situ hydrogen etching treatment is performed on the buffer layer 2 for 2 to 10 min;
(7) the steps (3) to (6) are repeated to complete the growth of a composite buffer layer, wherein the specific number of times of repetition is determined by a technologist according to an experiment result;
(8) the flow rates of the growth source and the doping source are changed in a gradual, linear manner; the SiH₄/H₂ flow rate ratio is controlled to be 0.1%; the C/Si ratio at the gas inlet end is controlled to be 1.2; hydrogen chloride is introduced, and the Cl/Si ratio at the gas inlet end is set to be 2.5; 10 sccm of nitrogen is introduced; the epitaxial time is set to be 15 min; all the values are set to be set values required by growing an epitaxial structure, and the epitaxial structure is grown according to a conventional process procedure; and
(9) after the growth of the epitaxial structure is completed, the growth source and the doping source are turned off; the temperature of the reaction chamber is reduced to room temperature in a hydrogen atmosphere; the hydrogen is discharged after the temperature of the reaction chamber reaches the room temperature; the gas in the reaction chamber is replaced by argon ; the reaction chamber is vacuumized to 0 mbar which is maintained for 5 min; the reaction chamber is filled with the argon to the atmospheric pressure; and the chamber is opened to take out a wafer.

In a hydrogen etching process, a proper amount of process gas such as the hydrogen chloride, the propane, the silanc or the trichlorosilanc may be introduced to assist in the hydrogen etching, and the technologist may select and determine the gas according to an actual situation.

The buffer layer 1 and the buffer layer 2 in the step 3 and the step 5 have different doping concentrations, which may be realized by changing the C/Si ratio at the gas inlet end or the flow rate of the doping source. For n-type doping, the doping concentration is in inverse proportion to the C/Si ratio at the gas inlet end, and for p-type doping, the doping concentration is in direct proportion to the C/Si ratio at the gas inlet end. In either n-type doping or p-type doping, the doping concentration is in direct proportion to the flow rate of the doping source.

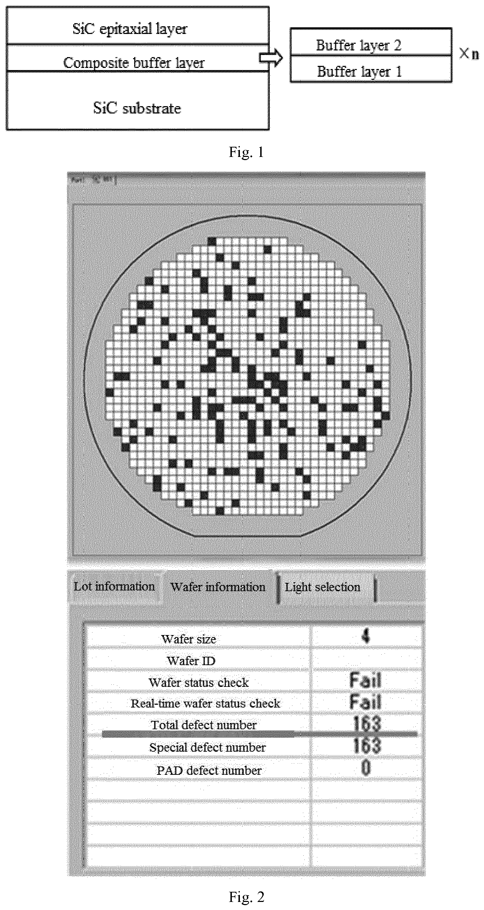

As shown in Fig. 1, the structure of an epitaxial wafer grown according to the present invention has a plurality of composite buffer layers. Situations of a composite buffer layer with one cycle of highly-lightly doped structure and a composite buffer layer with two cycles of highly-lightly doped structures are described below through two examples.

### Example 1

Growth of an SiC epitaxial wafer on the composite buffer layer with one cycle of highly-slightly doped structure includes the following specific steps that:
(1) a silicon-plane silicon carbide substrate deflected towards a direction <11-20> at 4 degrees was used and had a substrate BPD defect density of 1,000 cm⁻²; the substrate was placed on a graphite susceptor in a reaction chamber of an SiC epitaxial system, wherein the graphite susceptor was provided with a tantalum carbide coating layer;
(2) gas in the reaction chamber was replaced by argon for multiple times; then hydrogen was introduced into the reaction chamber; the flow rate of the H₂ was gradually increased to 80 L/min; a pressure in the reaction chamber was set to be 100 mbar; the reaction chamber was gradually heated to 1,600°C; the temperature of the reaction chamber was maintained for 10 min after the temperature reaches a growth temperature, and pure hydrogen etching was performed on the substrate;
(3) silane (SiH₄) and propane (C₃H₈) at small flow rates were introduced into the reaction chamber; the SiH₄/H₂ ratio was controlled to be 0.025%; the C/Si ratio was controlled to be 0.9, and 500 seem of high-purity nitrogen was introduced; the growth time was set to be 6 min, and a buffer layer 1 with a thickness of 0.5 µm and a doping concentration of 2E18 cm⁻³ was grown;
(4) a growth source and the doping source were turned off, the pressure in the reaction chamber, the growth temperature and the flow rate of the H₂ were maintained constant, and in-situ hydrogen etching treatment was performed on the buffer layer 1 for 5 min;
(5) the silane and the propane were introduced into the reaction chamber, wherein the flow rate of the silane was the same as that in the step (3); the flow rate of the propane was increased; the C/Si ratio was controlled to be 1.2, and 500 sccm of high-purity nitrogen was introduced; the growth time was set to be 6 min, and a buffer layer 2 with a thickness of 0.5 µm and a doping concentration of 5E17 cm⁻³ was grown;
(6) the growth source and the doping source were turned off, the pressure in the reaction chamber, the growth temperature and the flow rate of the hydrogen were maintained constant, and in-situ hydrogen etching treatment was performed on the buffer layer 2 for 5 min;
(7) the flow rates of the silane, propane and nitrogen were changed in a gradual, linear manner; the SiH₄/H₂ flow rate ratio was controlled to be 0.1%; the C/Si ratio at the gas inlet end was set to be 1.2; hydrogen chloride was introduced, and the Cl/Si ratio at the gas inlet end was set to be 2.5; 10 sccm of nitrogen was introduced; the epitaxial time was set to be 15 min; and
(8) the growth source and the doping source were turned off; the temperature of the reaction chamber was reduced to room temperature in a hydrogen atmosphere; argon was introduced to replace the hydrogen in the reaction chamber; the reaction chamber was vacuumized to 0 mbar which was maintained for 5 min; the reaction chamber was filled with the argon to the atmospheric pressure; and the chamber was opened to take out a wafer. The surface of the epitaxial wafer was characterized by a PL (Physical Layer) imaging BPD detection method, and results were as shown in Fig. 2.

### Example 2

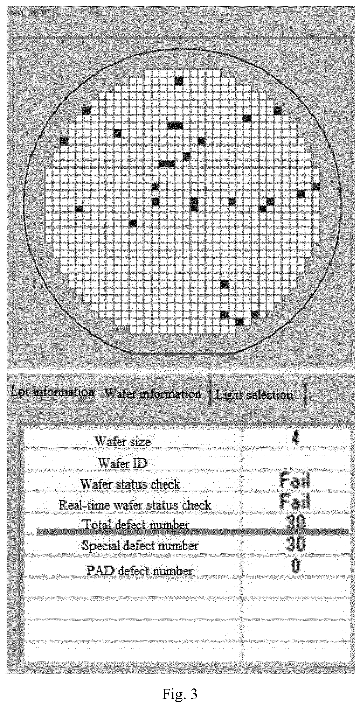

Growth of a SiC epitaxial wafer on the composite buffer layer with two cycles of highly-slightly doped structure includes the following specific steps that:
(1) a silicon-plane silicon carbide substrate deflected towards a direction <11-20> at 4 degrees was used and had a substrate BPD defect density of 1,000 cm⁻²; the substrate was placed on a graphite susceptor in a reaction chamber of an SiC epitaxial system, wherein the graphite susceptor was provided with a tantalum carbide coating layer;
(2) gas in the reaction chamber was replaced by argon for multiple times; then hydrogen was introduced into the reaction chamber; the flow rate of the H₂ was gradually increased to 80 L/min; a pressure in the reaction chamber was set to be 100 mbar; the reaction chamber was gradually heated to 1,600°C; the temperature of the reaction chamber was maintained for 10 min after the temperature reaches a growth temperature, and pure hydrogen etching was performed on the substrate;
(3) silane (SiH₄) and propane (C₃H₈) at small flow rates were introduced into the reaction chamber; the SiH₄/H₂ ratio was controlled to be 0.025%; the C/Si ratio was controlled to be 0.9, and 500 sccm of high-purity nitrogen was introduced; the growth time was set to be 6 min, and a buffer layer 1 with a thickness of 0.5 µm and a doping concentration of 2E18 cm⁻³ was grown;
(4) a growth source and the doping source were turned off, the pressure in the reaction chamber, the growth temperature and the flow rate of the H₂ were maintained constant, and in-situ hydrogen etching treatment was performed on the buffer layer 1 for 5 min;
(5) the silane and the propane were introduced into the reaction chamber, wherein the flow rate of the silane was the same as in the step (3); the flow rate of the propane was increased; the C/Si ratio was controlled to be 1.2, and 500 sccm of high-purity nitrogen was introduced; the growth time was set to be 6 min, and a buffer layer 2 with a thickness of 0.5 µm and a doping concentration of 5E17 cm⁻³ was grown;
(6) the growth source and the doping source were turned off, the pressure in the reaction chamber, the growth temperature and the flow rate of the hydrogen were maintained constant, and in-situ hydrogen etching treatment was performed on the buffer layer 2 for 5 min;
(7) the steps 3 to 6 were repeated once;
(8) the flow rates of the silane, propane and nitrogen were increased; the SiH₄/H₂ flow rate ratio was controlled to be 0.1%; the C/Si ratio at the gas inlet end was set to be 1.2; hydrogen chloride was introduced, and the Cl/Si ratio at the gas inlet end was set to be 2.5; 10 sccm of nitrogen was introduced; the epitaxial time was set to be 15 min; and
(9) the growth source and the doping source were turned off; the temperature of the reaction chamber was reduced to room temperature in a hydrogen atmosphere; argon was introduced to replace the hydrogen in the reaction chamber; the reaction chamber was vacuumized to 0 mbar which was maintained for 5 min; the reaction chamber was filled with the argon to the atmospheric pressure; and the chamber was opened to take out an epitaxial wafer. The surface of the epitaxial wafer was characterized by a PL imaging BPD detection method, and results were as shown in Fig. 3.

It can be seen from Fig. 2 and Fig. 3 that under this process, the BPD defect density of the epitaxial wafer grown on the composite buffer layer having one cycle of highly-lightly doped structure has been already reduced to 2.5 cm⁻², and the BPD conversion rate is up to 99.75%; the BPD defect density of the epitaxial wafer grown on the composite buffer layer having two cycles of highly-lightly doped structures has been already reduced to 0.5 cm⁻², and the BPD conversion rate is up to 99.95%. It can be seen that the BPD defect density in an epitaxial layer may be effectively reduced by combining interfacial high-temperature hydrogen treatment with a doping induction process. Meanwhile, the BPD defect density in the epitaxial layer may be further reduced by adding the repeat cycles of the highly-lightly doped structures in the composite buffer layer.

## Claims

1. A method for : growing a silicon carbide epitaxial layer with reduced basal plane dislocation density, comprising the following steps:
(1) placing a silicon carbide substrate deflected towards a direction <11-20> at 4 degrees or 8 degrees, on a graphite susceptor in a reaction chamber of a silicon carbide epitaxial system;
(2) replacing gas in the reaction chamber by argon, then introducing hydrogen into the reaction chamber, gradually increasing the flow rate of the hydrogen to 60 to 120 L/min, setting a pressure in the reaction chamber to be 80 to 200 mbar, gradually heating the reaction chamber to 1,550 to 1,700°C, maintaining all parameters constant after the temperature reaches a set temperature, and performing in-situ hydrogen etching treatment on the silicon carbide substrate for 5 to 15 min;
(3) after the in-situ hydrogen etching treatment is completed, introducing a silicon source and a carbon source into the reaction chamber, such that the flow rate ratio of the silicon source to the hydrogen is smaller than 0.03%, the C/Si ratio at the gas inlet end is controlled to be 0.9, and introducing a doping source to grow a buffer layer 1 with a thickness of 0.2 to 0.5 µm and a doping concentration of 2 to 5E18 cm⁻³;
(4) turning off the silicon source and the carbon source and the doping source, maintaining the pressure in the reaction chamber, the growth temperature and the flow rate of the hydrogen constant, and performing in-situ hydrogen etching treatment on the buffer layer 1 for 2 to 10 min;
(5) introducing the silicon source and the carbon source into the reaction chamber, such that the flow rate ratio of the silicon source to the hydrogen is the same as that in the step (3); and the C/Si ratio at the gas inlet end is controlled to be 1.2 introducing the doping source to grow a buffer layer 2 with a thickness of 0.2 to 0.5 µm and a doping concentration of 5 to 8E17 cm⁻³;
(6) turning off the silicon and the carbon source and the doping source, maintaining the pressure in the reaction chamber, the growth temperature and the flow rate of the hydrogen constant, and performing in-situ hydrogen etching treatment on the buffer layer 2 for 2 to 10 min;
(7) repeating the steps (3) to (6) to complete the growth of a composite buffer layer;
(8) introducing the silicon source and carbon source, and the doping source, changing the flow rates of the silicon source and carbon source, and the doping source, in a gradual, linear manner, so as to set set values which are values required for growing an epitaxial structure, and growing the epitaxial structure; and
(9) after the growth of the epitaxial structure is completed, turning off the growth source and the doping source, reducing the temperature of the reaction chamber to room temperature in a hydrogen atmosphere, then discharging the hydrogen, introducing argon to replace the gas in the reaction chamber, increasing the pressure in the reaction chamber to an atmospheric pressure by the argon, and opening the chamber to take out a wafer.

2. The method for reducing the silicon carbide epitaxial basal plane dislocation density according to claim 1, wherein the doping source is an n-type doping source nitrogen or a p-type doping source trimethylaluminum.

3. The method for reducing the silicon carbide epitaxial basal plane dislocation density according to claim 1, wherein the silicon source is silane, dichloro hydrogen silicon, trichlorosilane or tetrachloro hydrogen silicon, and the carbon source is methane, ethylene, acetylene or propane.

## Patentansprüche

1. Verfahren zum Wachsen einer epitaxialen Siliciumkarbid-1-Schicht mit reduzierter Versetzungsdichte in der Basisebene, umfassend die folgenden Schritte:
(1) Anordnen eines Siliciumkarbid-Substrats, das in einer Richtung <11-20> um 4 Grad oder 8 Grad abgelenkt wird, auf einem Graphitsuszeptor in einer Reaktionskammer eines epitaxialen Siliciumkarbid-Systems;
(2) Ersetzen von Gas in der Reaktionskammer durch Argon, dann Einleiten von Wasserstoff in die Reaktionskammer, allmähliches Erhöhen der Durchflussrate des Wasserstoffs auf 60 bis 120 L/min, Einstellen eines Drucks in der Reaktionskammer auf 80 bis 200 mbar, allmähliches Erwärmen der Reaktionskammer auf 1.550 bis 1.700°C, Konstanthalten aller Parameter, nachdem die Temperatur eine eingestellte Temperatur erreicht hat, und Durchführen einer in-situ-Wasserstoff-Ätzbehandlung auf dem Siliciumcarbid-Substrat für 5 bis 15 min;
(3) nach Abschluss der In-situ-Wasserstoff-Ätzbehandlung, Einbringen einer Siliciumquelle und einer Kohlenstoffquelle in die Reaktionskammer, so dass das Durchflussratenverhältnis der Siliciumquelle zum Wasserstoff kleiner als 0,03% ist;
wobei das C/Si-Verhältnis am Gaseinlassende auf 0,9 geregelt wird, und Einbringen einer Dotierungsquelle zum Wachsen einer Pufferschicht 1 mit einer Dicke von 0,2 bis 0,5 µm und einer Dotierungskonzentration von 2 bis 5E18 cm⁻³;
(4) Abschalten der Siliciumquelle und der Kohlenstoffquelle und der Dotierungsquelle, Konstanthalten des Drucks in der Reaktionskammer, der Wachstumstemperatur und der Durchflussrate des Wasserstoffs und Durchführen einer In-situ-Wasserstoff-Ätzbehandlung an der Pufferschicht 1 für 2 bis 10 Minuten;
(5) Einbringen der Siliciumquelle und der Kohlenstoffquelle in die Reaktionskammer, so dass das Durchflussratenverhältnis der Siliciumquelle zum Wasserstoff das gleiche ist wie in Schritt (3);
und wobei das C/Si-Verhältnis am Gaseinlass auf 1,2 geregelt wird; Einbringen der Dotierungsquelle zum Wachsen einer Pufferschicht 2 mit einer Dicke von 0,2 bis 0,5 µm und einer Dotierungskonzentration von 5 bis 8E17 cm⁻³;
(6) Abschalten der Silicium- und der Kohlenstoffquelle und der Dotierungsquelle, Konstanthalten des Drucks in der Reaktionskammer, der Wachstumstemperatur und der Durchflussrate des Wasserstoffs und Durchführen einer In-situ-Wasserstoff-Ätzbehandlung an der Pufferschicht 2 für 2 bis 10 Minuten;
(7) Wiederholen der Schritte (3) bis (6), um das Wachstum einer zusammengesetzten Pufferschicht abzuschließen;
(8) Einbringen der Siliciumquelle und der Kohlenstoffquelle sowie der Dotierungsquelle, wobei die Durchflussraten der Siliciumquelle und der Kohlenstoffquelle sowie der Dotierungsquelle allmählich und linear so verändert werden, dass Sollwerte eingestellt werden, die zum Wachsen einer epitaxialen Struktur erforderlich sind, und Wachsen der epitaxialen Struktur; und
(9) nach Abschluss des Wachstums der epitaxialen Struktur, Abschalten der Wachstumsquelle und der Dotierungsquelle, Absenken der Temperatur der Reaktionskammer auf Raumtemperatur in einer Wasserstoffatmosphäre, dann Entladen des Wasserstoffs, Einbringen von Argon, um das Gas in der Reaktionskammer zu ersetzen, Erhöhen des Drucks in der Reaktionskammer durch das Argon auf einen atmosphärischen Druck und Öffnen der Kammer zur Entnahme eines Wafers.

2. Verfahren zum Reduzieren der Versetzungsdichte der epitaktischen Basisebene von Siliciumcarbid nach Anspruch 1, wobei die Dotierungsquelle ein n-Typ-Dotierungsquellen-Stickstoff oder eine p-Typ-Dotierungsquelle-Trimethylaluminium ist.

3. Verfahren zum Reduzieren der Versetzungsdichte der epitaxialen Basisebene von Siliciumcarbid nach Anspruch 1, wobei die Siliciumquelle Silan, Dichlorwasserstoffsilicium, Trichlorsilan oder Tetrachlorwasserstoffsilicium ist und die Kohlenstoffquelle Methan, Ethylen, Acetylen oder Propan ist.

## Revendications

1. Procédé destiné à faire croître une couche épitaxiale 1 de carbure de silicium avec une densité de dislocation de plan basal réduite, comprenant les étapes suivantes :
(1) placement d'un substrat en carbure de silicium dévié vers une direction <11-20> à 4 degrés ou 8 degrés, sur un suscepteur en graphite dans une chambre de réaction d'un système épitaxial en carbure de silicium ;
(2) remplacement du gaz dans la chambre de réaction par de l'argon, puis introduction d'hydrogène dans la chambre de réaction, augmentation progressive du débit de l'hydrogène à 60 à 120 l/min, réglage d'une pression dans la chambre de réaction entre 80 et 200 mbars, chauffage progressif de la chambre de réaction entre 1 550 et 1 700 °C, maintien de tous les paramètres constants après que la température atteint une température définie, et réalisation d'un traitement de gravure à l'hydrogène in situ sur le substrat en carbure de silicium pendant 5 à 15 min ;
(3) une fois le traitement de gravure à l'hydrogène in situ terminé, introduction d'une source de silicium et d'une source de carbone dans la chambre de réaction, de sorte que le rapport de débit de la source de silicium à l'hydrogène est inférieur à 0,03 % ;
le rapport C/Si à l'extrémité d'entrée de gaz est commandé pour être de 0,9, et l'introduction d'une source de dopage pour faire croître une couche tampon 1 d'une épaisseur de 0,2 à 0,5 µm et d'une concentration de dopage de 2 à 5E18 cm⁻³ ;
(4) arrêt de la source de silicium et de la source de carbone et de la source de dopage, maintien de la pression dans la chambre de réaction, de la température de croissance et du débit de l'hydrogène constants, et réalisation d'un traitement de gravure à l'hydrogène in situ sur la couche tampon 1 pendant 2 à 10 minutes ;
(5) introduction de la source de silicium et de la source de carbone dans la chambre de réaction, de sorte que le rapport de débit de la source de silicium sur l'hydrogène est le même que celui de l'étape (3) ;
et le rapport C/Si à l'extrémité d'entrée de gaz est commandée pour être de 1,2 en introduisant la source de dopage pour faire croître une couche tampon 2 avec une épaisseur de 0,2 à 0,5 µm et une concentration de dopage de 5 à 8E17 cm⁻³ ;
(6) arrêt de la source de silicium et carbone et de la source de dopage, maintien de la pression dans la chambre de réaction, de la température de croissance et du débit de l'hydrogène constants, et réalisation d'un traitement de gravure à l'hydrogène in situ sur la couche tampon 2 pendant 2 à 10 min ;
(7) répétition des étapes (3) à (6) pour terminer la croissance d'une couche tampon composite ;
(8) introduction de la source de silicium et de la source de carbone, et de la source de dopage, modification des débits de la source de silicium et de la source de carbone, et de la source de dopage, de manière progressive et linéaire, afin de définir des valeurs de consigne qui sont des valeurs nécessaires destinées à faire croître une structure épitaxiale, et croissance de la structure épitaxiale ; et
(9) une fois la croissance de la structure épitaxiale terminée, arrêt de la source de croissance et de la source de dopage, réduction de la température de la chambre de réaction à température ambiante dans une atmosphère d'hydrogène, puis évacuation de l'hydrogène, introduction de l'argon pour remplacer le gaz dans la chambre de réaction, augmentation de la pression dans la chambre de réaction à une pression atmosphérique par l'argon, et ouverture de la chambre pour prélever une tranche.

2. Procédé destiné à réduire la densité de dislocation de plan basal épitaxial du carbure de silicium selon la revendication 1, dans lequel la source de dopage est un azote de source de dopage de type n ou un triméthylaluminium de source de dopage de type p.

3. Procédé de réduction de la densité de dislocation de plan basal épitaxial du carbure de silicium selon la revendication 1, dans lequel la source de silicium est du silane, du dichlorure hydrogène silicium, du trichlorosilane ou du tétrachlorure hydrogène silicium, et la source de carbone est du méthane, de l'éthylène, de l'acétylène ou du propane.
